# EUROPEAN PATENT SPECIFICATION

(11) **EP 2 195 810 B1**
(45) Date of publication and mention of the grant of the patent: **23.03.2011**
(21) Application number: 08787104.2
(22) Date of filing: 11.08.2008
(51) Int. Cl.: G11C 16/10

(54) **SYSTEM AND METHOD OF WRITING DATA IN A FLASH MEMORY ON THE BASIS OF ADDITIONAL REMOVABLE CONTACT PADS**
SYSTEM UND VERFAHREN ZUM SCHREIBEN VON DATEN IN EINEM FLASH-SPEICHER AUF DER BASIS ZUSÄTZLICHER ENTFERNBARER KONTAKTSTELLEN
SYSTÈME ET PROCÉDÉ D'ÉCRITURE DE DONNÉES DANS UNE MÉMOIRE FLASH SUR LA BASE DE PLAGES DE CONTACT AMOVIBLES SUPPLÉMENTAIRES

(30) Priority: 31.08.2007 EP 07291055
(43) Date of publication of application: 16.06.2010
(73) Proprietor: Gemalto SA, 92190 Meudon (FR)
(72) Inventor: GRAVEZ, Pierre, F-94130 Nogent Sur Marne (FR); GUIGNARD, Philippe, F-75008 Paris (FR); MARSEILLE, François-Xavier, F-78160 Marly Le Roi (FR); THILL, Michel, F-78340 Les Clayes Sous Bois (FR)
(86) International application number: PCT/EP2008/060530
(87) International publication number: WO 2009/027216

(56) References cited:
- GB-A- 2 332 981
- JP-A- 5 152 377
- JP-A- 2001 358 305
- US-A- 4 565 922
- US-A1- 2007 096 266

## Description

### (Field of the invention)

The present invention relates to system and methods of managing writing data in a flash memory. It relates particularly to systems and methods of personalization of flash memories intended to be embedded in an electronic token.

### (Prior art)

Flash memories embedded in electronic tokens have storage capacities which are more and more large. Consequently, size of data to be written in these Flash memories during personalization step is dramatically increasing. For example, storage capacities of these memories may reach several megabytes and should reach several gigabytes in the coming years. A controller component is connected to a Flash memory. The controller manages access to data stored in the flash memory. All incoming and outgoing data flows are treated by the controller. The controller is in charge of the translation between logical addresses and physical addresses.

A controller embedded in an electronic token like a smart card may be accessed through several physical interfaces: ISO contacts, Single-wire protocol (SWP) or USB. The USB interface offers a better flow capacity than the two other interfaces. Nevertheless controller performance is limited and may be a bottleneck when a high speed flow of data is provided by the interface, such as an USB interface. Thus the combination controller/USB interface may limit the flow of data written in the memory to be personalized.

The document US 2007/096266 A1 wherein the preamble of claim 1 is based describes a semiconductor package having semiconductor dies such as flash memories which are stacked in a three dimensional arrangement. An interface with connection pads allows accessing the flash memories.

The document GB-A-2 332 981 teaches a chip comprising memories having connection pads and contacts areas which are used during a testing step to take control of the memory interface and to write physical data into the memories. The contact areas are broken away after the test.

The document US-A-4 656 922 describes a key card wherein conduction lines are interrupted by punching a hole through them.

Moreover, several Flash memories may be connected to a unique controller. In this case the controller must manage all incoming and outgoing data flows related to connected memories. The data flow treated by the combination controller/USB interface is insufficient to reach acceptable performances at the time of the personalization of large volumes of data. For example, the USB interface allows reaching up to 12 Megabit/second in full speed. The combination of such USB interface with a controller is able to manage up to 8 Megabit/second. In other words, the writing of 100 Megabytes takes 100 seconds. In a second example, with an USB interface in intermediate Speed, the combination USB interface/controller allows reaching 45 up to 72 Megabit/second. In other words, the writing of 100 Gigabytes takes between 100 and 180 seconds.

The above mentioned duration of writing of large amount of data in a flash memory is incompatible with the constraints of output awaited in manufacturing stage. For example the personalization of a memory intended to be embedded in an electronic token like a SIM card is currently around 10 seconds.

### (Summary of the Invention)

The invention aims at minimizing the treatment duration required for writing data in a flash memory intended to be embedded in an electronic token.

The object of the present invention is a system of managing writing operation in a first flash memory intended to be embedded in an electronic token. Said first flash memory has an interface comprising a plurality of connection pads, and is attached to a lead frame. Said method comprises the following steps of
- generating a set of contact areas on the lead frame, each of said contact areas being intended to be directly bound to one connection pad of the first flash memory,
- taking the control of the memory interface,
- sending physical data to the memory interface through the contact areas,
- writing the physical data in the first flash memory,
- removing the set of contact areas from the lead frame by a punch operation.

Logical data may be stored in a second memory and the method may comprise the step of reading Bad block data in said first flash memory attached to the lead frame, and the step of generating physical data from both Bad block data and Logical data.

Alternatively, Initial data may be stored in a third memory. A parameter data may be stored in a fourth memory. The method may comprise the step of generating Logical data from both initial data and parameter data.

Advantageously, the parameter data may depend on the type of said first flash memory.

Said first flash memory may be intended to be accessed by a controller component and the parameter data may depend on the type of controller component.

Advantageously, the method may comprise the following additional steps after the step of writing physical data:
- attaching a controller component on the lead frame,
- bonding the controller component,
- coating with resin the controller component and the first flash memory.

The method may comprise the following steps before the step of reading Bad block data:
- attaching a controller component on the lead frame,
- bonding the controller component and the first flash memory,
- coating with resin the controller component and the first flash memory.

Advantageously, the method may comprise the step of setting the controller component in an inactive state before the step of taking the control of the memory interface.

The first flash memory may be a NAND flash memory.

The electronic token may be a smart card, a portable audio device, a mobile handset, a personal digital assistant or a USB token.

Another object of the invention is a writing system comprising a microprocessor and a plurality of contact areas intended for writing physical data in at least one flash memory attached to a lead frame. Said contact areas are adapted for establishing an electric connection with a set of contact areas of the lead frame previously described.

Advantageously, the writing system may comprise a memory storing Logical data. Said writing system may comprise first means for reading bad block data in the flash memory attached to the lead frame, second means for generating physical data from logical data and bad block data and third means for writing the physical data in the flash memory attached to the lead frame.

Said second means may be adapted for generating physical data suited for being managed by a controller component attached to the lead frame, said controller component being connected to the flash memory attached to the lead frame.

Another object of the invention is an apparatus comprising several previously described writing systems. Said writing systems are connected through USB links.

### (Brief description of the drawings)

Other characteristics and advantages of the present invention will emerge more clearly from a reading of the following description of a number of preferred embodiments of the invention with reference to the corresponding accompanying drawings in which:
- Figure 1 is a first example of a sequence of steps for writing data in a flash memory according to the invention;
- Figure 2 depicts an example of the lead frame comprising contact areas according to the invention;
- Figure 3 is a second example of a sequence of steps for writing data in a flash memory according to the invention;
- Figure 4a depicts schematically an example of the architecture of controller component that may be used for an embodiment of the invention;
- Figure 4b depicts an example of chronogram of events for disconnection of a controller component according to the invention;
- Figure 5 depicts schematically the architecture of a writing system comprising contact areas according to the invention; and
- Figure 6 depicts schematically an example of the architecture of an apparatus comprising several writing systems according to the invention.

### (Detailed description of the preferred embodiments)

The invention may apply to writing of data in any types of flash memory. In particular, it may apply to writing data in flash memory in an electronic token like a smart card, a USB token, or a mobile handset. In this specification, the electronic token is a smart card but it could be any other kind of portable device having a flash memory, like a portable audio device or a personal digital assistant. In this specification, the flash memory is a NAND flash memory but it could be any other kind of flash memory.

An advantage of the invention is to allow keeping unchanged the final physical interface of the combination controller/flash memory. In particular, when the personalized flash memory is embedded in a smart card, the eight ISO electric contacts remains unchanged.

Since no additional wire is required on the lead frame, another advantage of the invention is the low production cost. Moreover the invention does not require any new personalization features in the smart card operating system.

The invention allows taking advantage of the speed offered by the direct interface of a flash memory. For example, data flow managed by a typical NAND flash memory interface may reach 160 Megabit/second with a clock set to 20 MHz. In the future, interface flow managed by a typical NAND flash memory interface may reach up to 320 Megabit/second with a clock set to 40 MHz.

The flow of writing data inside a NAND memory may reach up to 80 Megabit/second. In the case of interlaced writing process, the writing speed may almost be doubled.

Thus while avoiding crossing the bottleneck of the combination controller/USB interface, the speed of data writing in flash memory is significantly improved at personalization stage.

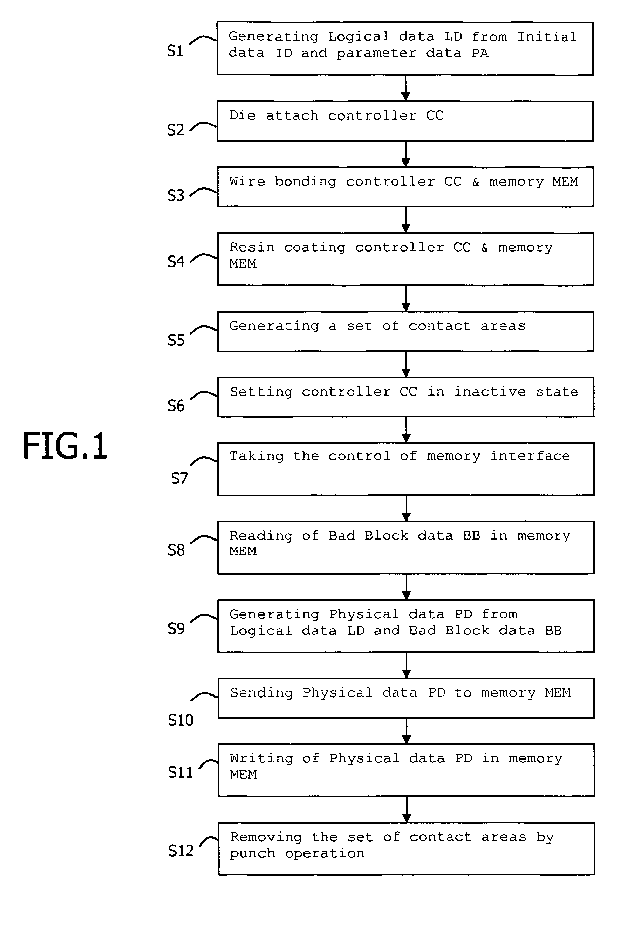

Figure 1 shows a first example of a step sequence for writing data in a flash memory according to the invention. This example aims at storing initial data ID in the flash memory MEM. The flash memory MEM is supposed to be already attached to a lead frame LF. A controller component CC is supposed to be added to the lead frame. The flash memory MEM is intended to be accessed and managed by the controller component CC through a Flash Translation Layer. Specific parameter data PA is identified. This parameter data PA depends on both the type of NAND memory, the type of controller component CC and on the type of Flash Translation Layer that will be used.

Logical data LD is generated from initial data ID and parameter data PA at step S1. This Logical data LD corresponds to data with a logical address as managed by the high layers of the Flash Translation Layer.

Then at step S2, the controller component CC is attached to the lead frame LF.

Alternatively if the flash memory MEM was not already attached to the lead frame LF, the flash memory MEM may attached to the lead frame LF at step S2. This step is known as the "die attach" step.

Then at step S3, the controller component CC and the flash memory MEM are bonded on the lead frame LF. This step is known as the "wire bonding" step.

At step S4, both controller component CC and the flash memory MEM are resin coated.

Then at step S5, a set of contact areas is generated on the lead frame LF. The number of contact areas depends on the flash memory to be written and may be easily defined by a person skilled in the art of flash memory. Each generated contact areas is connected to a Nand memory connection pad in order to build a new physical interface for accessing the Nand memory MEM.

The set of contact areas may be generated by serigraphy or conductive matter jet.

Alternatively, the set of contact areas may be included beforehand in the design of the lead frame. In this case, the set of contact areas is generated on the lead frame LF before the step of die attach of the flash memory MEM.

At step S6, the controller component CC is set to an inactive state. The inactive state corresponds to a state where the controller does not supply power to the NAND flash memory. The Nand port interface is disconnected or turned to a high impedance state. The controller component deactivation may be performed either through the ISO contacts or through dedicated additional contact areas linked to the controller component CC.

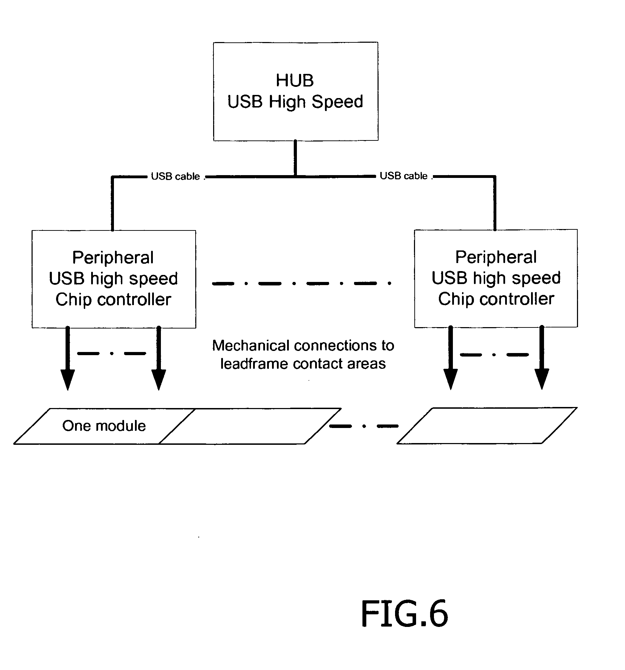

At step S7, contact is established between the set of contact areas and a production equipment such as a peripheral USB high speed chip controller drawn at figure 6. The contact may be established thanks to a probe card belonging to the production equipment. Then a writing system takes the control of the interface of the flash memory MEM to be written.

At step S8, the writing system reads Bad block data BB in the flash memory MEM. Bad block data BB corresponds to the list of bad blocks known for the flash memory component. The bad block data BB varies from a flash memory component to another one.

Then Physical data PD is generated from Logical data LD and Bad block data BB at step S9. This Physical data PD corresponds to data with a physical address as managed by the low layers of the Flash Translation Layer.

At step S10, Physical data PD is send to the flash memory MEM.

Then at step S11, Physical data PD is written in the flash memory MEM.

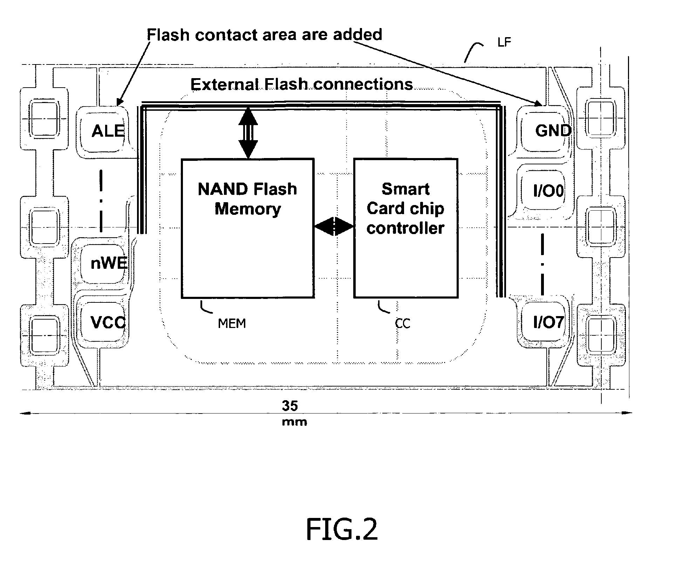

At step S12, the set of contact areas is removed from the lead frame LF through a punch operation. The punch operation is well known by a person skilled in the art of flash memory personalization. The NAND memory connection pads are now disconnected from the contact areas may which remain on the useless punched tape. For example, the punch operation may be performed according to the dotted line drawn at figure 2.

Figure 2 shows an example of the lead frame LF after the step S5 of generating contact areas. The NAND flash memory MEM is connected to the controller component CC. Generated contact areas ALE, nWE, VCC, GND, I/00 to I/07 are connected to the NAND memory pads. In this example only six contacts areas are present in order not to overload the drawing. The number of contact areas may be higher than six. For instance the number of contact areas may be equal to 14.

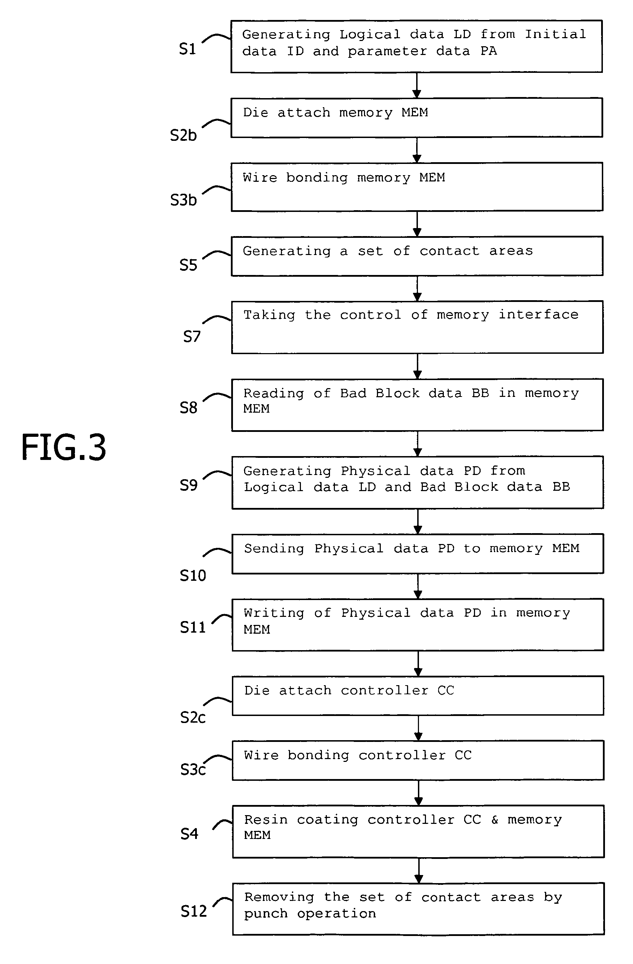

Another example of step sequence for writing data in a flash memory according to the invention is shown at figure 3. This second example has many steps similar to the first example. In this second example, the controller component CC is attached to the lead frame after the writing of data in the NAND flash memory MEM.

Thus, before the step S5 of generating a set of contact areas on the lead frame LF, the additional step S3b is performed. The step S3b corresponds to the "wire bonding" of the NAND flash memory.

Alternatively if the flash memory MEM was not already attached to the lead frame LF, the flash memory MEM may be attached to the lead frame LF at step S2b. This step is known as the "die attach" step.

Between the step S11 of writing Physical data PD and the step S12 of removing contact areas, several additional steps may be performed: S2c and S3c. The step S2c corresponds to the "die attach" of the controller component CC to the lead frame LF. The step S3c corresponds to the "wire bonding" of the controller component CC on the lead frame LF. Then the step S4 corresponding to the resin coating is performed.

In the second example, the step S6 of setting the controller component CC in an inactive state is not necessary.

Alternatively, most of the steps may be performed in an order different from that presented in the previous examples. For instance, The step S1 of generating Logical data LD may be performed after the step S8 of reading Bad block data BB from the flash memory MEM.

In both examples, the controller component CC may be customized through the usual ISO interface at a further personalization stage.

In both examples, the logical data LD and the physical data PD are generated so that the data really written in the memory are identical to those which would have been written by a traditional writing process.

An advantage of the invention is to allow a reuse of the generated Logical data LD for the writing in several flash memories of the same type. The time required for generating Logical data LD is saved when several flash memories may share the same Logical data LD. Only Physical data must be generated for a unique flash memory component.

Moreover, the Logical data LD may be generated outside the writing system. In this case, means for generating the Logical data LD are not required in the writing system. This makes the writing system cheap and easy to be developed.

An additional advantage of the invention is to allow providing personalized flash memory without any additional available contact areas remaining on the final product. For security reasons, it is very important that there is no direct interface for accessing the flash memory MEM on the final product.

Advantageously, the Bad block data BB may be updated during the step S11 of writing physical data PD. In this case, physical data PD is regenerated on the fly according to the new bad blocks found in the flash memory MEM. Then the updated Bad block data BB may be written in a dedicated part of the flash memory MEM.

As previously described, the controller component CC is set to an inactive state at step S6 after the controller CC has been attached on the lead frame LF before the step of writing in the flash memory MEM. The purpose of this deactivation step S6 is to shut off the power supply of the controller CC. Another purpose of this deactivation step S6 is to set the NAND interface of the controller CC in a state of not conduction. In other words, the flash memory interface of the controller CC must be set with high impedance. The deactivation step S6 is necessary in order to allow power supplying of the NAND flash memory MEM through the generated contact areas without disturbance.

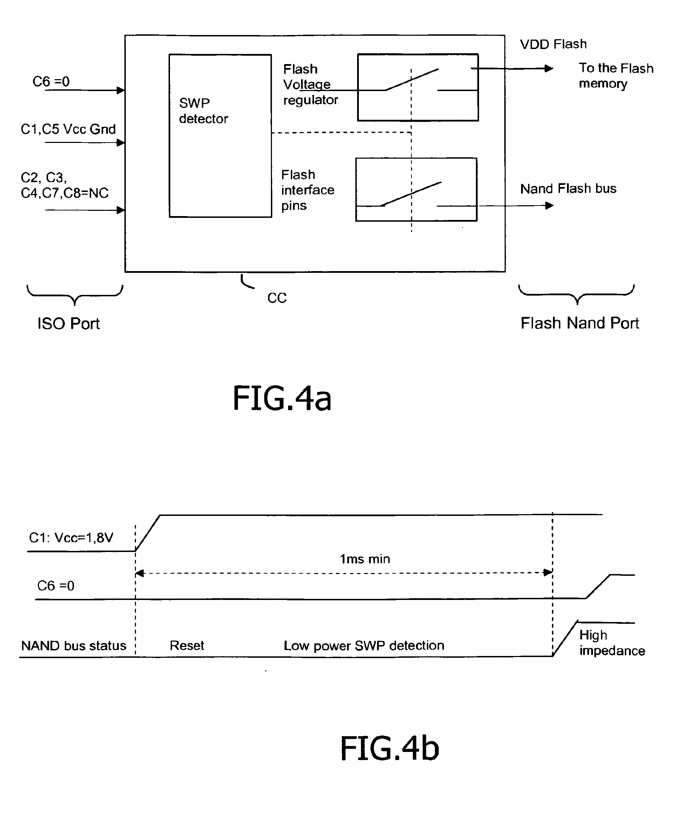

Figure 4a depicts an example of the architecture of controller component CC of the Atmel ® AT91SC512384RCT type.

This kind of component comprises a Single-wire protocol (SWP) detector, a flash voltage regulator, a set of flash interface pins and a set of ISO contacts C1, to C8.

This type of component has a flash memory controller comprising two main features:
- the power supplying of a NAND flash memory via VDD flash, and
- the management of NAND signals like nRE, nCE, CLE, ALE, nWE, nWP, I00 to I07.

This kind of component can be used in a low power consumption mode where only a subset of its features is available. The low power consumption mode is related to the use of Single-wire protocol (SWP). In this case, the controller component may be used in Near Filed Communication (NFC) context. Thus the controller component may be powered trough an antenna. In this case the available electric output is limited and does not allow the use of the connected flash memory. The flash voltage regulator is disconnected and the NAND flash memory interface is set to high impedance state.

Figure 4b depicts an example of low power consumption mode detection. The C6 contact of the controller corresponds to the Single-wire protocol (SWP). When the C6 contact is kept to low state - equal to zero - during the powering of the controller at 1,8v, the SWP detector is activated. This operation simulates the detection of a near electromagnetic field. After a duration of approximately one millisecond, the controller component remains in low power consumption mode as long as the logical level of C6 contact remains equal to zero. Thus the controller component is set in an inactive state and a writing system may be connected to the generated contact areas for accessing the flash memory MEM.

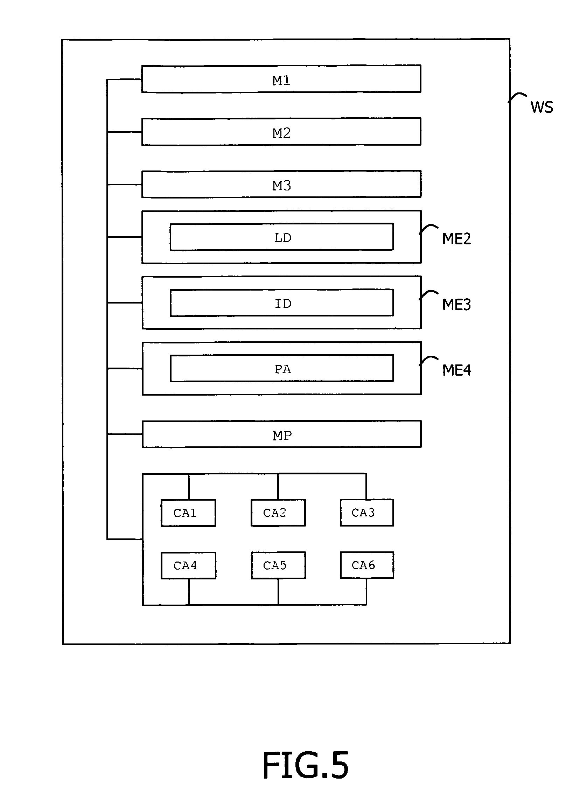

Figure 5 depicts a writing system WS allowing writing in a flash memory according to the previously described methods. The writing system WS comprises a microprocessor MP, a memory ME2 storing Logical data LD and a plurality of contact areas CA1, CA2, ... , CA6 intended for writing Physical data (PD) in a flash memory MEM attached to a lead frame LF. The contact areas of writing system WS are adapted for establishing an electric connection with a set of contact areas of the lead frame LF according to above described methods. The number of contact areas on Figure 5 is set to six but the real number of contact areas may be different. In particular, the number of contact areas may be equal to 14.

The writing system WS comprises first means M1 for reading bad block data BB in the flash memory MEM attached to the lead frame LF. The writing system WS comprises second means M2 for generating physical data PD from logical data LD and bad block data BB. The writing system WS comprises third means M3 for writing the physical data PD in the flash memory MEM attached to the lead frame LF.

The writing system WS may comprise a memory ME3 for storing initial data IA. The writing system WS may comprise a memory ME4 for storing parameter data PA. The writing system WS may comprise a memory ME5 for storing Bad block data BB. All memories of the writing system WS may be of the same type or different types. Memories ME3, ME4 and ME5 may be placed in on or several systems connected to the writing system WS.

Figure 6 shows an example of apparatus comprising several writing systems WS connected through USB links. The apparatus comprises a hub that provides the logical data LD to the writing systems WS named peripheral USB chip controller. This apparatus allow writing of several flash memories at the same time.

## Claims

1. A method of managing writing operation in a first flash memory (MEM) intended to be embedded in an electronic token, said first flash memory (MEM) having an interface comprising a plurality of connection pads, and being attached to a lead frame (LF),
**characterized in that** said method comprises the following steps:
- generating (S5) a set of contact areas (ALE, nWE, I/00, I/07, VCC, GND) on the lead frame (LF), each of said contact areas being intended to be directly bound to one connection pad of the first flash memory (MEM),
- taking (S7) the control of the memory interface,
- sending (S10) physical data (PD) to the memory interface through the contact areas (ALE, nWE, I/00, I/07, VCC, GND),
- writing (S11) the physical data (PD) in the first flash memory (MEM),
- removing (S12) the set of contact areas (ALE, nWE, I/00, I/07, VCC, GND) from the lead frame (LF) by a punch operation.

2. The method according to claim 1, wherein Logical data (LD) is stored in a second memory (ME2) and wherein the method comprises the following steps:
- reading (S8) Bad block data (BB) in said first flash memory (MEM) attached to the lead frame (LF),
- generating (S9) physical data (PD) from both Badblock data (BB) and Logical data (LD).

3. The method according to claim 2, wherein initial data (ID) is stored in a third memory (ME3), wherein parameter data (PA) is stored in a fourth memory (ME4) and wherein the method comprises the following step:
- generating (S1) Logical data (LD) from both initial data (ID) and parameter data (PA).

4. The method according to claim 3, wherein parameter data (PA) depends on the type of said first flash memory (MEM).

5. The method according to claim 3 or 4, wherein said first flash memory (MEM) is intended to be accessed by a controller component (CC) and wherein the parameter data (PA) depends on the type of controller component (CC).

6. The method according to one of the previous claim, wherein the method comprises the following steps after the step (S11) of writing physical data (PD):
- attaching (S2c) a controller component (CC) on the lead frame (LF),
- bonding (S3c) the controller component (CC),
- coating with resin (S4) the controller component (CC) and the first flash memory (MEM).

7. The method according to claim 2, 3, 4 or 5, wherein the method comprises the following steps before the step (S8) of reading Bad block data (BB):
- attaching (S2) a controller component (CC) on the lead frame (LF),
- bonding (S3) the controller component (CC) and the first flash memory (MEM),
- coating with resin (S4) the controller component (CC) and the first flash memory (MEM).

8. The method according to claim 7, wherein the method comprises the following step:
- setting (S6) the controller component (CC) in an inactive state before the step (S7) of taking the control of the memory interface.

9. The method according to one of the previous claims, wherein the first flash memory (MEM) is a NAND flash memory.

10. The method according to one of the previous claims, wherein the electronic token is a smart card, a portable audio device, a mobile handset, a personal digital assistant or a USB token.

11. A writing system (WS) comprising a microprocessor (MP) and a plurality of contact areas (CA1, CA2, ... , CA6) intended for writing physical data (PD) in at least one flash memory (MEM) attached to a lead frame (LF), **characterized in that** said contact areas (CA1, CA2, ... , C6) are adapted for establishing an electric connection with a set of contact areas (ALE, nWE, I/00, I/07, VCC, GND) of the lead frame and **in that** the writing system (WS) is able to write in said at least one flash memory (MEM) according to the method of claim 1.

12. The writing system (WS) according to claim 11, wherein said writing system (WS) comprises a memory (ME2) storing Logical data (LD) and wherein said writing system (WS) comprises first means (M1) for reading bad block data (BB) in the flash memory (MEM) attached to the lead frame (LF), second means (M2) for generating physical data (PD) from logical data (LD) and bad block data (BB) and third means (M3) for writing the physical data (PD) in the flash memory (MEM) attached to the lead frame (LF).

13. The writing system (WS) according to claim 12, wherein said second means (M2) are adapted for generating physical data (PD) suited for being managed by a controller component (CC) attached to the lead frame (LF), said controller component (CC) being connected to the flash memory (MEM) attached to the lead frame (LF).

14. An apparatus comprising several writing systems (WS) according to claim 13 wherein said writing systems (WS) are connected through USB links.

## Patentansprüche

1. Ein Verfahren für das Verwalten eines Vorgangs zum Schreiben in einen ersten Flash-Speicher (MEM), der in ein elektronisches Objekt eingebettet werden soll, wobei der besagte erste Flash-Speicher (MEM) eine Schnittstelle hat, die eine Mehrzahl von Kontakt-Pads umfasst und an einem Lead-Frame-Modul(LF) befestigt ist,
**dadurch gekennzeichnet, dass** das besagte Verfahren die nachstehenden Schritte umfasst:
- Erzeugen (S5) eines Satzes von Kontaktbereichen (ALE, nWE, I/00, I/07, VCC, GND) auf dem Lead-Frame-Modul (LF), wobei jeder der besagten Kontaktbereiche direkt mit einem Kontakt-Pad des ersten Flash-Speichers verbunden werden soll,
- Übernehmen (S7) der Kontrolle der Speicherschnittstelle,
- Senden (S10) von physischen Daten (PD) durch die Kontaktbereiche (ALE, nWE, I/00, I/07, VCC, GND) an die Speicherschnittstelle,
- Schreiben (S11) der physischen Daten (PD) in den ersten Flash-Speicher (MEM),
- Entfernen (S12) des Satzes von Kontaktbereichen (ALE, nWE, I/00, I/07, VCC, GND) vom Lead-Frame-Modul (LF) durch einen Stanzvorgang.

2. Das Verfahren nach Anspruch 1, **dadurch gekennzeichnet, dass** Logikdaten (LD) in einem zweiten Speicher (ME2) gespeichert werden, und **dadurch**, dass das Verfahren die nachstehenden Schritte umfasst:
- Lesen (S8) von beschädigten Datenblöcken (BB) im besagten ersten Flash-Speicher (MEM), der am Lead-Frame-Modul(LF) befestigt ist,
- Erzeugen (S9) von physischen Daten (PD) aus den beschädigten Datenblöcken (BB) und den Logikdaten (LD).

3. Das Verfahren nach Anspruch 2, **dadurch gekennzeichnet, dass** Initialdaten (ID) in einem dritten Speicher (ME3) gespeichert werden, und **dadurch**, dass Parameterdaten (PA) in einem vierten Speicher (ME4) gespeichert werden, und **dadurch**, dass das Verfahren den folgenden Schritt umfasst:
- Erzeugen (S1) von Logikdaten (LD) aus den Initialdaten (ID) und den Parameterdaten (PA).

4. Das Verfahren nach Anspruch 3, **dadurch gekennzeichnet, dass** Parameterdaten (PA) vom Typ des besagten ersten Flash-Speichers (MEM) abhängen.

5. Das Verfahren nach Anspruch 3 oder 4, **dadurch gekennzeichnet, dass** auf den besagten ersten Flash-Speicher (MEM) über eine Controller-Komponente (CC) zugegriffen werden soll, und **dadurch**, dass die Parameterdaten (PA) vom Typ der Controller-Komponente (CC) abhängen.

6. Das Verfahren nach einem beliebigen der vorstehenden Ansprüche, **dadurch gekennzeichnet, dass** das Verfahren nach dem Schritt (S11) mit Schreiben der physischen Daten (PD) die nachstehenden Schritte umfasst:
- Befestigen (S2c) einer Controller-Komponente (CC) auf dem Lead-Frame-Modul (LF),
- Aufkleben (S3c) der Controller-Komponente (CC),
- Überziehen der Controller-Komponente (CC) und des ersten Flash-Speichers (MEM) mit Harz (S4).

7. Das Verfahren nach Anspruch 2, 3, 4 oder 5, **dadurch gekennzeichnet, dass** das Verfahren vor dem Schritt (S8) mit Lesen von beschädigten Datenblöcken (BB) die nachstehenden Schritte umfasst:
- Befestigen (S2) einer Controller-Komponente (CC) auf dem Lead-Frame-Modul (LF),
- Aufkleben (S3) der Controller-Komponente (CC) und des ersten Flash-Speichers (MEM),
- Überziehen der Controller-Komponente (CC) und des ersten Flash-Speichers (MEM) mit Harz (S4).

8. Das Verfahren nach Anspruch 7, **dadurch gekennzeichnet, dass** das Verfahren den nachstehenden Schritt umfasst:
- Versetzen (S6) der Controller-Komponente (CC) vor dem Schritt (S7) mit Übernehmen (S7) der Kontrolle der Speicherschnittstelle in einen inaktiven Status.

9. Das Verfahren nach einem beliebigen der vorstehenden Ansprüche, **dadurch gekennzeichnet, dass** der erste Flash-Speicher (MEM) ein NAND Flash-Speicher ist.

10. Das Verfahren nach einem beliebigen der vorstehenden Ansprüche, **dadurch gekennzeichnet, dass** das elektronische Objekt eine Smartcard, ein tragbares Audio-Gerät, ein mobiles Handgerät, ein PDA (Personal Digital Assistant) oder ein USB-Objekt ist.

11. Ein Schreibsystem (WS), das einen Mikroprozessor (MP) und eine Mehrzahl von Kontaktbereichen (CA1, CA2, ..., CA6) umfasst, das zum Schreiben von physischen Daten (PD) in zumindest einen Flash-Speicher (MEM) bestimmt ist, der an einem Lead-Frame-Modul (LF) befestigt ist, **dadurch gekennzeichnet, dass** die besagten Kontaktbereiche (CA1, CA2, ..., CA6) geeignet sind, eine elektrische Verbindung mit einem Satz von Kontaktbereichen (ALE, nWE, I/00, I/07, VCC, GND) des Lead-Frame-Moduls herzustellen, und **dadurch**, dass das Schreibsystem (WS) fähig ist, nach dem Verfahren aus Anspruch 1 in den besagten zumindest ersten Flash-Speicher (MEM) zu schreiben.

12. Das Schreibsystem (WS) nach Anspruch 11, **dadurch gekennzeichnet, dass** das besagte Schreibsystem (WS) einen Speicher (ME2) umfasst, der Logikdaten (LD) speichert, und **dadurch**, dass das besagte Schreibsystem (WS) erste Mittel (M1) zum Lesen von beschädigten Datenblöcken (BB) im Flash-Speicher (MEM) umfasst, der am Lead-Frame-Modul (LF) befestigt ist, und zweite Mittel (M2) zum Erzeugen physischer Daten (PD) aus Logikdaten (LD) und beschädigten Datenblöcken (BB) und dritte Mittel (M3) zum Schreiben der physischen Daten (PD) in den Flash-Speicher (MEM), der am Lead-Frame-Modul (LF) befestigt ist.

13. Das Schreibsystem (WS) nach Anspruch 12, **dadurch gekennzeichnet, dass** die besagten zweiten Mittel (M2) geeignet sind, physische Daten (PD) zu erzeugen, die von einer am Lead-Frame-Modul (LF) befestigten Controller-Komponente (CC) verwaltet werden können, wobei die besagte Controller-Komponente (CC) mit dem Flash-Speicher (MEM) verbunden ist, der am Lead-Frame-Modul (LF) befestigt ist.

14. Ein Aufbau, der mehrere Schreibsysteme (WS) nach Anspruch 13 umfasst, **dadurch gekennzeichnet, dass** die besagten Schreibsysteme (WS) über USB Links verbunden sind.

## Revendications

1. Procédé de gestion de l'opération d'écriture dans une première mémoire flash (MEM) conçue pour être intégrée dans un jeton électronique, ladite première mémoire flash (MEM) ayant une interface comprenant une pluralité de pastilles de connexion, et étant fixée sur une grille de connexion (LF),
**caractérisé en ce que** ledit procédé comprend les étapes suivantes :
- la génération (S5) d'un ensemble de zones de contact (ALE, Nwe, I/00, I/07, VCC, GND) sur la grille de connexion (LF), chacune desdites zones de contact étant destinée à être directement reliée à une pastille de connexion de la première mémoire flash (MEM),
- la prise (S7) du contrôle de l'interface mémoire,
- l'envoi (S10) de données physiques (PD) vers l'interface mémoire par les zones de contact (ALE, Nwe, I/00, I/07, VCC, GND),
- l'écriture (S11) des données physiques (PD) dans la première mémoire flash (MEM),
- le retrait (S12) de l'ensemble de zones de contact (ALE, Nwe, I/00, I/07, VCC, GND) de la grille de connexion grâce à une opération de poinçonnage.

2. Procédé selon la revendication 1, dans lequel les données logiques (LD) sont stockées dans une deuxième mémoire (ME2) et dans lequel le procédé comprend les étapes suivantes :
- la lecture (S8) des données de bloc défectueux (BB) dans ladite première mémoire flash (MEM) fixée à la grille de connexion (LF),
- la génération (S9) de données physiques (PD) à partir de, à la fois, les données de bloc défectueux (BB) et les données logiques (LD).

3. Procédé selon la revendication 2, dans lequel les données initiales (ID) sont stockées dans une troisième mémoire (ME3), dans lequel les données de paramètres (PA) sont stockées dans une quatrième mémoire (ME4) et dans lequel le procédé comprend l'étape suivants :
- la génération (S1) de données logiques (LD) à partir de, à la fois, les données initiales (ID) et les données de paramètre (PA).

4. Procédé selon la revendication 3, dans lequel les données de paramètre (PA) dépendent du type de ladite première mémoire flash (MEM).

5. Procédé selon les revendications 3 ou 4, dans lequel un composant de contrôle (CC) est destiné à avoir accès à ladite première mémoire flash (MEM) et dans lequel les données de paramètre (PA) dépendent du type du composant de contrôle (CC).

6. Procédé selon l'une des revendications précédentes, dans lequel le procédé comprend les étapes suivantes, après l'étape (S11) d'écriture de données physiques (PD) :
- la fixation (S2c) d'un composant de contrôle (CC) sur la grille de connexion (LF),
- la liaison (S3c) du composant de contrôle (CC),
- le revêtement avec de la résine (S4) du composant de contrôle (CC) et de la première mémoire flash (MEM).

7. Procédé selon les revendications 2, 3, 4 ou 5, dans lequel le procédé comprend les étapes suivantes avant l'étape (S8) de lecture des données de bloc défectueux (BB) :
- la fixation (S2) d'un composant de contrôle (CC) sur la grille de connexion (LF),
- la liaison (S3) du composant de contrôle (CC) et de la première mémoire flash (MEM),
- le revêtement avec de la résine (S4) du composant de contrôle (CC) et de la première mémoire flash (MEM).

8. Procédé selon la revendication 7, dans lequel le procédé comprend l'étape suivants :
- le placement (S6) du composant de contrôle (CC) dans un état inactif avant l'étape (S7) consistant à prendre le contrôle de l'interface mémoire.

9. Procédé selon l'une des revendications précédentes, dans lequel la première mémoire flash (MEM) est une mémoire flash NON-ET.

10. Procédé selon l'une des revendications précédentes, dans lequel le jeton électronique est une carte à microprocesseur, un dispositif audio portable, un téléphone portable, un assistant numérique personnel ou un jeton USB.

11. Système d'écriture (WS) comprenant un microprocesseur (MP) et une pluralité de zones de contact (CA1, CA2, ..., CA6) destinées à l'écriture de données physiques (PD) dans au moins une mémoire flash (MEM) fixée à une grille de connexion (LF), **caractérisé en ce que** lesdites zones de contact (CA1, CA2, ..., CA6) sont conçues pour établir une connexion électrique avec un ensemble de zones de contact (ALE, nWE, I/00, I/07, VCC, GND) de la grille de connexion et **en ce que** le système d'écriture (WS) est apte à écrire dans ladite au moins une mémoire flash (MEM) selon le procédé de la revendication 1.

12. Système d'écriture (WS) selon la revendication 11, dans lequel ledit système d'écriture (WS) comprend une mémoire (ME2) stockant des données logiques (LD) et dans lequel ledit système d'écriture (WS) comprend des premiers moyens (M1) permettant de lire des données de bloc défectueux (BB) dans la mémoire flash (MEM) fixée à la grille de connexion (LF), des deuxièmes moyens (M2) permettant de générer des données physiques (PD) à partir des données logiques (LD) et des données de bloc défectueux (BB) et des troisièmes moyens (M3) permettant d'écrire les données physiques (PD) dans la mémoire flash (MEM) fixée sur la grille de connexion (LF).

13. Système d'écriture (WS) selon la revendication 12, dans lequel lesdits deuxièmes moyens (M2) sont conçus pour générer des données physiques (PD) adaptées pour être gérées par un composant de contrôle (CC) fixé sur la grille de connexion (LF), ledit composant de contrôle (CC) étant connecté à la mémoire flash (MEM) fixée sur la grille de connexion (LF).

14. Appareil comprenant plusieurs systèmes d'écriture (WS) selon la revendication 13, dans lequel lesdits systèmes d'écriture (WS) sont connectés par des liaisons USB.
